# EUROPEAN PATENT APPLICATION

(11) **EP 4 683 450 A1**
(43) Date of publication of application: **21.01.2026**
(21) Application number: 24894542.0
(22) Date of filing: 16.11.2024
(51) Int. Cl.: H05K 9/00, H05K 7/14, H01M 50/284

(54) **BMW GROUNDING DEVICE INCLUDING BOSS HOLE AND GROUNDING PIN**

(30) Priority: 22.11.2023 KR 20230163579
(71) Applicant: LG Energy Solution, Ltd., Seoul 07335 (KR)
(72) Inventor: KIM, Hak Soon, Daejeon 34122 (KR); JANG, Jae Young, Daejeon 34122 (KR)
(74) Representative: Plasseraud IP
(86) International application number: PCT/KR2024/018130
(87) International publication number: WO 2025/110649

(57) **Abstract**

Disclosed is a BMU grounding device including a BMU having a boss hole, a fixing pin extending through the boss hole, the fixing pin including a conductive material, and a case located on a lower surface of the BMU, the case being configured to allow the BMU to be fixed thereto, wherein the fixing pin includes a head and a body, the head being supported by an upper surface of the BMU, and the case includes an insertion portion into which the fixing pin extending through the boss hole is inserted and a brush disposed around the insertion portion, the brush being coupled to the fixing pin in tight contact therewith, the brush including a conductive material. Consequently, it is possible to provide stabilization by grounding while insulating the entirety of a battery in a BMU of a battery pack for laptop computers.

## Description

### [Technical Field]

This application claims the benefit of priority to Korean Patent Application No. 2023-0163579 filed on November 22, 2023, the disclosure of which is incorporated herein by reference in its entirety.

The present invention relates to a battery management unit (BMU) grounding device including a boss hole and a grounding pin. More particularly, the present invention relates to a BMU grounding device including a boss hole for fixing a BMU to an apparatus and a novel grounding pin for grounding the BMU using the same.

### [Background Art]

In the case of a lithium secondary battery, the temperature, the voltage, and the like of a battery cell are measured and monitored for the purpose of safety. A PCB manufactured for this purpose is called a battery management unit (BMU). IT products such as smartphones and laptop computers are becoming smaller and lighter, whereas battery modules or battery packs used therein are becoming denser while having higher capacity. Due to the limited space available for components, the BMU is also becoming very dense. Nevertheless, for highly mobile IT products, the BMU must essentially be provided with a boss hole for fixing the BMU to an IT product.

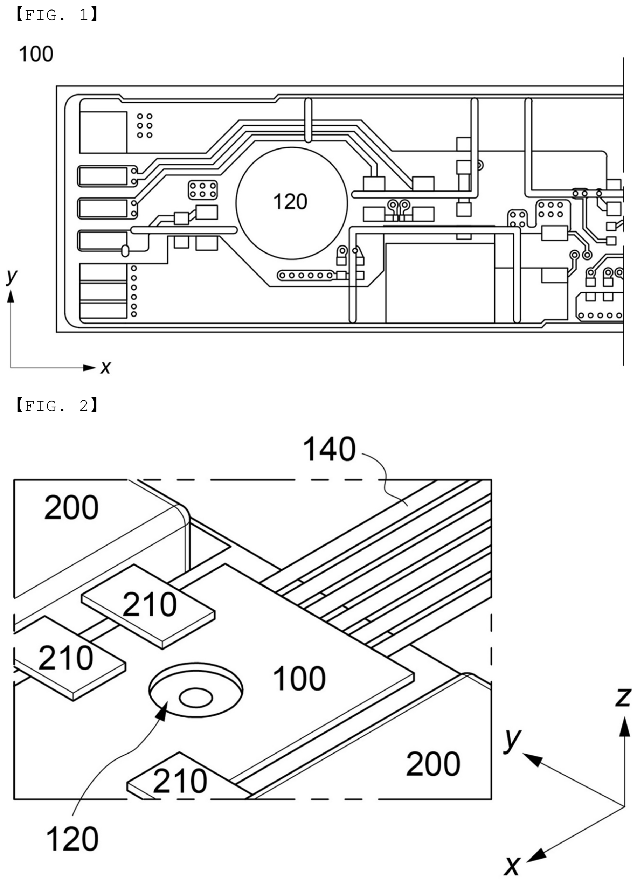

FIG. 1 is a schematic view showing a part of an upper surface of a conventional BMU 100 according to a related art, and FIG. 2 is a perspective view showing a part of the configuration of a BMU in a conventional battery pack according to a related art. The xyz coordinates shown in FIGS. 1 and 2 are the same. Referring to FIGS. 1 and 2, a BMU 100 is disposed in the center of a battery cell 200 having electrode leads 210, and the BMU 100 is connected to external current lines 140. A boss hole 120 for fixing the BMU 100 is also provided.

For components used in IT devices, electrostatic discharge (ESD) verification is required. BMUs used in battery modules or battery packs also need to be prepared for ESD.

TVS diodes, Zener diodes, etc. may be used in order to prevent product damage due to ESD, but there may not be a grounding pattern that can utilize these elements, or even if these elements are provided, the design may avoid the elements, causing ESD. For a boss hole provided in a PCB, a bolt/nut is typically used to fix the PCB for noise reduction and grounding connection.

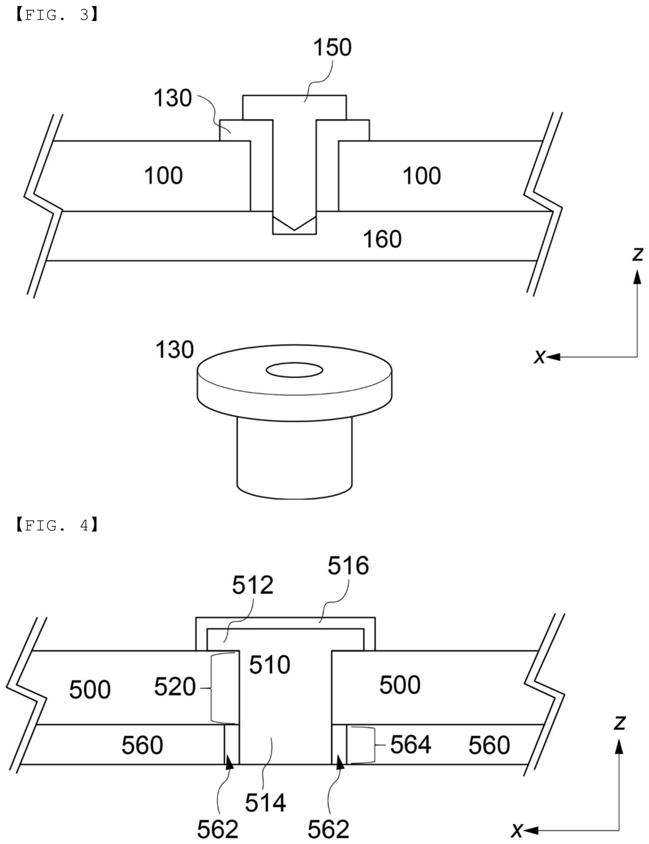

FIG. 3 is a sectional view of a conventional bolt/nut grounding connection according to a related art. The upper figure of FIG. 3 is a sectional view of the bolt/nut grounding connection, and the lower figure is a perspective view of the nut used. Referring to FIG. 3, a boss hole is provided in a PCB of a BMU 100, and a nut 130 made of metal is inserted into the boss hole. The nut 130 and the PCB are electrically connected to each other. The nut 130 and the PCB may be further fixed to each other by soldering. The nut 130 is also in contact with a metal case 160. The nut 130 and the BMU 100 are fixed to each other by a bolt 150.

For recent laptop computers, a very thin battery pack is used, and the battery pack necessarily includes a BMU. The BMU may also be subjected to ESD problems, and in order to avoid the problems, a conventional bolt/nut type grounding connection may be employed.

However, in practice, the entirety of the battery pack is insulated for stability of laptop computers. A protrusion formed by injection molding of resin is inserted into a boss hole of a BMU provided in the battery pack for laptop computers to fix the BMU to a case of the laptop computer. If a conventional bolt/nut type connection is employed, the safety of the battery pack may be reduced by the bolt exposed above the BMU.

Patent Document 1 relates to a printed board that keeps the connection impedance between a printed wiring board and a case low to suppress the generation of the potential difference at a GND level, thereby reducing noise generation. Patent Document 1 provides a printed wiring board having a plurality of screw holes 8 for installing a printed wiring board 3 in a GND-connected case 3 and a plurality of through-holes 5 for contacting the case 3 around screw holes of an electrically connected conductor land 11.

A secondary battery connection structure according to Patent Document 2 includes a fastening portion 262a or a screw fastening portion 262b provided at a circuit connection portion 242 of a metal plate 202 and circuit terminal portions 402a and 402b located on a PCB 1 of a protection circuit module 300, wherein the fastening portion 262a or the screw fastening portion 262b of the circuit connection portion 242 and the circuit terminal portions 402a and 402b are electrically connected to each other by a selectively connectable and detachable physical connection.

In Patent Documents 1 and 2, grounding connection is performed in the boss hole of the PCB through the bolt/nut connection, which is difficult to apply to a laptop computer used in the present invention.

In a BMU of a battery pack for laptop computers, there is no technology capable of providing stabilization by grounding while insulating the entirety of a battery.

### (Prior Art Documents)

(Patent Document 1) Japanese Patent Application Publication No. 2014-090018
(Patent Document 2) Korean Registered Patent Publication No. 1245286

### [Disclosure]

### [Technical Problem]

It is an object of the present invention to provide technology capable of providing stabilization by grounding while insulating the entirety of a battery in a BMU of a battery pack for laptop computers.

### [Technical Solution]

In order to accomplish the above object, the present invention provides a BMU grounding device including a BMU having a boss hole, a fixing pin extending through the boss hole, the fixing pin including a conductive material, and a case located on a lower surface of the BMU, the case being configured to allow the BMU to be fixed thereto, wherein the fixing pin includes a head and a body, the head being supported by an upper surface of the BMU, and the case includes an insertion portion into which the fixing pin extending through the boss hole is inserted and a brush disposed around the insertion portion, the brush being coupled to the fixing pin in tight contact therewith, the brush including a conductive material.

The BMU is a battery management unit, which may be used in any device using a secondary battery. In the present invention, however, the BMU may be applied particularly to IT products such as smartphones and laptop computers.

The fixing pin may be electrically connected to the BMU. Specifically, the head of the fixing pin and the BMU may be electrically connected to each other. The head may be connected to some circuits of a PCB of the BMU.

An outer periphery of the head may be surrounded by a non-conductive material. Specifically, a separate rubber cap may be provided at the outer periphery of the head, or the outer periphery of the head may be coated with a non-conductive material. As a result, insulation of the battery pack used in the laptop computer may be maintained.

The brush may be coupled to the body of the fixing pin in tight contact therewith by an elastic force. Specifically, the brush may be configured as a leaf spring coupled to the body of the fixing pin in tight contact therewith, or the brush may be supported by a coil spring, wherein the part of the brush in contact with the body of the fixing pin may be configured as a metal plate. At least one brush may be provided. The brush may serve to physically fix the fixing pin as well as electrically contacting the same. To this end, two or more brushes are preferably provided.

The brush may also be in contact with the case. Grounding and fixing may be performed by the fixing pin and the brush, and the entirety of the case may be made of metal, or only the part of the case in contact with the brush may be made of metal to perform a grounding function.

A lower part of the body of the fixing pin may be tapered. This may facilitate insertion of the fixing pin into the insertion portion of the case through the boss hole.

The BMU may include a PCB layer and a frame. A separate label may be added to the outermost side of a battery pack used in a laptop computer, etc.

The frame may include a non-conductive material. Consequently, grounding may be performed only by the fixing pin and the case, and the remainder may remain insulated.

In addition, the present invention provides a laptop computer including the BMU grounding device.

The present invention may provide any possible combinations of the above solving means.

### [Advantageous Effects]

The present invention provides a BMU grounding device including a BMU having a boss hole, a fixing pin extending through the boss hole, the fixing pin being made of a conductive material, and a case located on a lower surface of the BMU, the case being configured to allow the BMU to be fixed thereto, wherein the fixing pin includes a head and a body, the head being supported by an upper surface of the BMU, and the case includes an insertion portion into which the fixing pin extending through the boss hole is inserted and a brush disposed around the insertion portion, the brush being coupled to the fixing pin in tight contact therewith, the brush being made of a conductive material. In the present invention, therefore, it is possible to provide stabilization by grounding while insulating the entirety of a battery in a BMU of a battery pack for laptop computers.

In addition, it is possible to provide a grounding function while easily fixing the battery pack using the fixing pin and the brush, unlike a conventional bolt/nut type connection. It is possible to achieve manufacturing efficiency and weight reduction by reducing the number of components that are used.

### [Description of Drawings]

FIG. 1 is a schematic view showing a part of an upper surface of a conventional BMU.
FIG. 2 is a perspective view showing a part of the configuration of a BMU in a conventional battery pack.
FIG. 3 is a sectional view of a conventional bolt/nut grounding connection.
FIG. 4 is a schematic view of a BMU grounding device according to the present invention.
FIG. 5 is a schematic view of a BMU grounding device according to a first embodiment of the present invention.

### [Best Mode]

Now, preferred embodiments of the present invention will be described in detail with reference to the accompanying drawings such that the preferred embodiments of the present invention can be easily implemented by a person having ordinary skill in the art to which the present invention pertains. In describing the principle of operation of the preferred embodiments of the present invention in detail, however, a detailed description of known functions and configurations incorporated herein will be omitted when the same may obscure the subject matter of the present invention.

In addition, the same reference numbers will be used throughout the drawings to refer to parts that perform similar functions or operations. In the case in which one part is said to be connected to another part throughout the specification, not only may the one part be directly connected to the other part, but also, the one part may be indirectly connected to the other part via a further part. In addition, that a certain element is included does not mean that other elements are excluded, but means that such elements may be further included unless mentioned otherwise.

Hereinafter, the present invention will be described with reference to the accompanying drawings. FIG. 4 is a schematic view of a BMU grounding device according to the present invention. Referring to FIG. 4, the present invention provides a BMU grounding device including a BMU 500 having a boss hole 520, a fixing pin 510 extending through the boss hole 520, the fixing pin being made of a conductive material, and a case 560 located on a lower surface of the BMU 500, the case being configured to allow the BMU 500 to be fixed thereto, wherein the fixing pin 510 includes a head 512 and a body 514, the head 512 being supported by an upper surface of the BMU 500, and the case 560 includes an insertion portion 564 into which the fixing pin 510 extending through the boss hole 120 is inserted and a brush 562 disposed around the insertion portion 564, the brush being coupled to the fixing pin 510 in tight contact therewith, the brush being made of a conductive material.

The head 512 of the fixing pin 510 and the BMU 500 are electrically connected to each other. Specifically, the head 512 is connected to some circuits of a PCB of the BMU 500.

An outer periphery of the head 512 is surrounded by a rubber cap 516 made of a non-conductive material.

The brush 562 is coupled to the body 514 of the fixing pin 510 in tight contact therewith by elastic force. The brush 562 serves to physically fix the fixing pin 510 as well as electrically contacting the same. To this end, two brushes are provided.

The brush 562 is also in contact with the case 560. Grounding and fixing are performed by the fixing pin 510 and the brush 562, and the entirety of the case is made of metal.

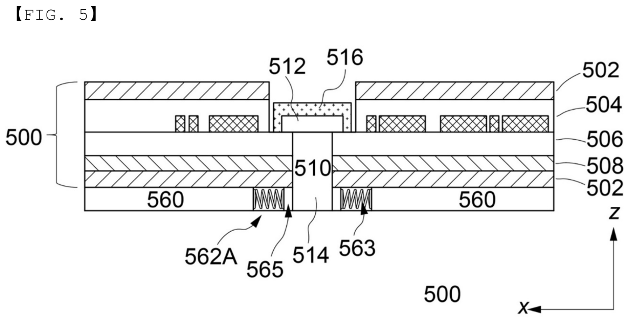

FIG. 5 is a schematic view of a BMU grounding device according to a first embodiment of the present invention. FIG. 5 shows the schematic view of FIG. 4 in more detail, and therefore a duplicate description will be omitted.

The BMU 500 includes a label 502, a BMU cover 504, a PCB 506, a frame 508, and a label 502, which are sequentially disposed from above. The label 502 corresponds to a type of adhesive paper that is adhered to the outermost side. The frame 508 is made of a non-conductive material. Consequently, grounding is performed only by the fixing pin 510 and the case 560, and the remainder may remain insulated.

A brush 562A is supported by a coil spring 563, and the part of the brush in contact with the body 514 of the fixing pin 510 is configured as a metal plate 565. At least two brushes 562A are provided. The brush 562A is also fixed to the case 560 made of metal in contact therewith.

The brush 562A of FIG. 5 includes a metal plate 565 and a coil spring 563, but the brush may be configured as a leaf spring. The brush of the present invention may be made of any conductive and elastic material.

Although not shown in the figure, a lower part of the body of the fixing pin may be tapered. This may facilitate insertion of the fixing pin into the insertion portion of the case through the boss hole.

Although the specific details of the present invention have been described in detail, those skilled in the art will appreciate that the detailed description thereof discloses only preferred embodiments of the present invention and thus does not limit the scope of the present invention. Accordingly, those skilled in the art will appreciate that various changes and modifications are possible, without departing from the category and the technical idea of the present invention, and it will be obvious that such changes and modifications fall within the scope of the appended claims.

### (Description of Reference Symbols)

100, 500: BMUs
120, 520: Boss holes
130: Nut
140: External current line
150: Bolt
160, 560: Metal cases
200: Battery cell
210: Electrode lead
502: Label
504: BMU cover
506: PCB
508: Frame
510: Fixing pin
512: Head
514: Body
516: Rubber cap
562, 562A: Brushes
563: Coil spring
565: Metal plate
564: Insertion portion

## Claims

1. A BMU grounding device comprising:
a BMU having a boss hole;
a fixing pin extending through the boss hole, the fixing pin including a conductive material; and
a case located on a lower surface of the BMU, the case being configured to allow the BMU to be fixed thereto, wherein
the fixing pin comprises a head and a body, the head being supported by an upper surface of the BMU, and
the case comprises:
an insertion portion into which the fixing pin extending through the boss hole is inserted, and
a brush disposed around the insertion portion, the brush being coupled to the fixing pin in tight contact therewith, the brush including a conductive material.

2. The BMU grounding device according to claim 1, wherein the fixing pin is electrically connected to the BMU.

3. The BMU grounding device according to claim 2, wherein the head of the fixing pin and the BMU are electrically connected to each other.

4. The BMU grounding device according to claim 1, wherein an outer periphery of the head is surrounded by a non-conductive material.

5. The BMU grounding device according to claim 1, wherein the brush is coupled to the body of the fixing pin in tight contact therewith by an elastic force.

6. The BMU grounding device according to claim 5, wherein a lower part of the body of the fixing pin is tapered.

7. The BMU grounding device according to claim 1, wherein the brush is in contact with a grounding portion of the case.

8. The BMU grounding device according to claim 1, wherein the BMU comprises a PCB layer and a frame.

9. The BMU grounding device according to claim 8, wherein the frame layer includes a non-conductive material.

10. A laptop computer comprising the BMU grounding device according to any one of claims 1 to 9.
